# EUROPEAN PATENT SPECIFICATION

(11) **EP 0 306 153 B1**
(45) Date of publication and mention of the grant of the patent: **22.03.1995**
(21) Application number: 88307262.1
(22) Date of filing: 05.08.1988
(51) Int. Cl.: H01L 21/20, C30B 25/18

(54) **Method for growth of crystal**
Verfahren zum Züchten eines Kristalls
Méthode pour la croissance d'un cristal

(30) Priority: 08.08.1987 JP 198690/87
(43) Date of publication of application: 08.03.1989
(73) Proprietor: CANON KABUSHIKI KAISHA, Tokyo (JP)
(72) Inventor: Yonehara, Takao, Atsugi-shi Kanagawa-ken (JP); Yamagata, Kenji, Atsugi-shi Kanagawa-ken (JP); Nishigaki, Yuji, Odawara-shi Kanagawa-ken (JP)
(74) Representative: Beresford, Keith Denis Lewis

(56) References cited:
- US-A- 4 052 782
- US-A- 4 216 037
- US-A- 4 657 603
- PATENT ABSTRACTS OF JAPAN, vol. 7, no. 161 (C-176)[1306], 15th July 1983; & JP-A-58 69 798
- PATENT ABSTRACTS OF JAPAN, vol. 8, no. 172 (C-237)[1609], 9th August 1984; & JP-A-59 69 495
- IDEM
- PATENT ABSTRACTS OF JAPAN, vol. 10, no. 317 (E-449)[2373], 28th October 1986; & JP-A-61 127 117
- PATENT ABSTRACTS OF JAPAN, vol. 9, no. 302 (E-362)[2025], 29th November 1985; & JP-A-60 140 813
- IDEM
- PATENT ABSTRACTS OF JAPAN, vol. 7, no. 166 (E-188)[1311], 21st July 1983; & JP-A-58 74 034
- BRITISH JOURNAL OF APPLIED PHYSICS, vol. 18, no. 10, October 1967, pages 1357-1382, GB; J.D. FILBY et al.: "Single-crystal films of silicon on insulators"
- Appl. Phys. Letters. vol 44, no. 6, pp. 603-605(1984);
- Mat Res. Soc. Symp. vol. 25, ELsevier Science Publ. Co., pp. 517-524, (1984)
- Glow Discharge Processes, Brian Chapman, John Wiley & Sons, pp. 201-203 (1980)

## Description

This invention relates to a method for growing monocrystalline material, which can be used for, for example, electronic devices such as semiconductor integrated circuits, optical integrated circuits, magnetic circuits, etc., optical devices, magnetic devices, piezoelectric devices, or surface acoustic devices, etc.

In the prior art, a monocrystal of thin film to be used for semiconductor electronic devices or optical device has been formed by epitaxial growth on a monocrystal substrate. For example, on a Si monocrystal substrate (silicon wafer), Si, Ge, GaAs, etc. have been known to be epitaxially grown from liquid phase, gas phase or solid phase, and also on a GaAs monocrystal substrate, a monocrystal such as GaAs, GaAlAs, etc. has been known to be epitaxially grown. By use of the semiconductor thin film thus formed, semiconductor devices and integrated circuits, emission devices such as semiconductor laser or LED, etc. is prepared.

Also, recently, ultra-high speed transistor by use of two-dimensional electron gas, ultra-lattice device, utilizing quantum well, etc. have been actively studied and developed. What has made these techniques possible are high precision epitaxial techniques such as MBE (molecular beam epitaxy by use of ultra-high vacuum), MOCVD (metalloorganic chemical vapour deposition), etc.

In such epitaxial growth on a monocrystal substrate, it is necessary to adjust the lattice constants and coefficients of thermal expansion between the monocrystal material of the substrate and the epitaxial growth layer. If this adjustment is insufficient, lattice defects will be developed in the epitaxial layer. Also, the element constituting the substrate may sometimes diffuse into the epitaxial layer.

Thus, the method for forming a thin film monocrystal of the prior art by epitaxial growth can be understood to be greatly dependent on the substrate material. Matthews et al has examined combinations of substrate materials and epitaxial growth layers (EPITAXIAL GROWTH, Academic Press, New York, 1975 ed. by J.W. Matthews).

The size of substrate is presently about 15 cm (6 inch) in the case of Si wafer, and enlargement of GaAs, or sapphire, substrates has been delayed further. In addition, since monocrystal substrates are higher in cost, the cost per chip becomes higher.

Thus, for monocrystal growth capable of preparing a device of good quality, there has been a problem that the kinds of substrate materials have been limited to a very narrow range.

On the other hand, research and development has been abundantly made for accomplishing high integration of and multi-function of three-dimensional integrated circuits by laminating semiconductor devices in the direction normal to the substrate, and also research and development has been actively done in recent years for large area semiconductor devices such as solar batteries, switching transistors of liquid crystal picture elements, etc. in which devices are arranged in an array on an inexpensive glass.

What is common in all of these is that it is necessary to have a technique of forming a thin film monocrystal of semiconductor on an amorphous insulating material and forming an electronic device such as transistor, etc. thereon. Among them, it has been particularly desired to have a technique of forming a monocrystal semiconductor of high quality on an amorphous insulating material.

Generally speaking, when a thin film is deposited on a substrate of an amorphous insulating material such as Si0₂, etc., due to deficiency of long distance order of the substrate material, the deposited film will have a crystalline structure which is amorphous or polycrystalline. Here, amorphous film is a film in which the short distance order to the extent of the nearest atoms may be maintained, but there is no longer distance order, while polycrystalline film is a film in which monocrystal grains, having no specific crystal orientation, are gathered together separated by grain boundaries.

For example, when Si monocrystals are to be formed on Si0₂ by the CVD method, if the deposition temperature is about 600°C or lower, they will become amorphous silicon, and at higher temperature polycrystalline silicon with grain sizes distributed between some ten to hundred nm (hundred to some thousand angstroms). However, the particle sizes of polycrystalline silicon and distribution thereof will vary greatly depending on the method for formation.

Further, by melting and solidifying amorphous or polycrystalline film with an energy beam such as laser, rod-shaped heater, etc., polycrystalline films with larger grain size of about »m to millimeter size have been obtained (monocrystal silicon on non-single-crystal insulators, Journal of Crystal Growth, Vol. 63, No. 3, October, 1983 edited by G.W. Cullen).

On the thin film of the respective crystal structures thus formed, transistors were formed, and from their characteristics, electron mobilities were measured and compared with that of monocrystalline silicon. As a result, polycrystalline silicon with a large grain size of some »m to some mm obtained by melting solidification has a mobility to the same extent as in the case of monocrystal silicon, while the polycrystalline silicon having a grain size distribution of some ten to hundred nm (hundred to thousand angstroms) has a mobility which is about 10⁻³ of that in the case of monocrystalline silicon. In the case of amorphous silicon, an electron mobility to the extent of about 2 x 10⁻⁴ of that in the case of monocrystalline silicon is obtained.

From these results, it can be understood that there is a great difference in electrical characteristics between a device formed in the monocrystal domain within crystal grains and a device formed over a grain boundary. That is, a deposited film on the amorphous material obtained by the prior art method will become an amorphous structure or a polycrystalline structure having a grain size distribution, and a device prepared thereon becomes greatly deteriorated in its performance as compared with a device prepared on a monocrystal layer. For this reason, uses are limited to simple switching devices, solar battery, photoelectric transducing device, etc.

Also, the method of forming a polycrystalline thin film with greater grain size by melting and solidification has involved problems such as enormous time required for enlargement of grain size, poor bulk productivity and also incompatibility with enlargement of area, because amorphous or monocrystal thin film is scanned with an energy beam for every wafer.

As described above, according to many previous methods of forming monocrystalline material, three-dimensional integration or enlargement of area could be done only with difficulty and it has been near impossible to form monocrystalline material for device that can lead to preparation of the devices having excellent characteristics, easily and at low cost.

It is mentioned that Japanese Patent Application published as No. 59-69495 on 19 April 1984 describes a method of growing monocrystalline material in which a patterned film of gold is produced on an Si0₂ surface and oriented single crystal seeds of silicon are produced upon heating and vapour deposition of silicon. The patterned film has the form of stripes but other shapes such as square or parallelogram are usable as alternative. Film materials other than gold consisting in metals which form a eutectic with silicon also may be used as alternative to gold. Before epitaxial growth of silicon monocrystalline material it is however necessary to chemically treat the substrate to remove surplus metal (gold) and it is also necessary to chemically treat the substrate to remove amorphous silicon formed in the interstices of the patterned film. Such chemical treatment steps add to the complexity and cost of the method described.

Recent research reported in the Materials Research Society Symposia Proceedings, Volume 25 (1984), Elsevien Science Publishing Co., pp 517-524 entitled "Abnormal grain growth in ultra-thin films of germanium on insulator" involved a series of experiments using continuous and striped films of germanium on a Si0₂ surface. A grating relief pattern was applied to the surface. Agglomeration was found for ultra-thin film at elevated annealing temperatures. In the case of continuous film the agglomerates formed were random in position. In the case of the stripes the agglomerates were formed aligned with the grating but otherwise were random in position and size. The crystallographic texture (face orientation) of these agglomerates was not determined because of this thickness. The hope is expressed in this paper that with further development of experiments on Ge graphoepitaxy, these experiments will lead to growth of large-area oriented single crystal films usable as seed layers for subsequent epitaxial growth.

The present invention is intended as a solution to the above problems of the prior art and provides a method for growth of monocrystal material which can be easily integrated three-dimensionally or enlarged in area, easily applied practically for devices and also which can lead to production of devices having excellent characteristics.

The present invention, a method of growing monocrystalline material, is provided as set out in claim 1 of the claims attached.

The present invention can be embodied to provide a method for growing monocrystalline material in which monocrystalline thin film can be formed even on a substrate of large area such as glass, in which an amorphous insulating substrate is used or in which any other substrate having heat resistance to the process temperature in the post-treatment step or higher can be used.

The present invention can also be embodied as a method in which small area monocrystalline material is formed at desired positions on the substrate and crystals are grown until the respective monocrystals collide against each other, where it is possible to determine the sizes of the grown monocrystals by choosing distances between the small area monocrystals.

Since in the method of the present invention the monocrystal material grown thereon has a uniform face orientation, and there will be little variance of the device characteristics of devices formed on the monocrystal material, this method is suitable for integrated device production.

In the accompanying drawings:
Fig. 1 is a graph showing the relationship between film thickness and agglomerating temperature of Ge concerning agglomeration of ultra-thin film;
Fig. 2(A) to Fig. 3(B) are diagrams for illustration of an embodiment of the present invention, Fig. 2(A) to 2(E) showing diagrams of steps; and Fig. 3(A) and Fig. 3(B) are perspective views.

In the present invention, heat treatment is applied to the primary seeds arranged on a non-nucleation surface as mentioned above to give rise to agglomeration.

More specifically, the present invention utilises the phenomenon of mono-crystallisation of primary seeds with a uniform face orientation during agglomeration as described above, and producing monocrystalline seeds with a uniform face orientation on a non-nucleation surface, thereby permitting selective epitaxial growth from each of the primary seeds.

Since the non-nucleation surface has a small nucleation density for the monocrystalline material to be grown substantially no nucleation and crystal growth will occur from this surface, and crystal growth occurs selectively from the fine agglomerated product which is monocrystalline seed.

The thickness of each primary seed arranged on the non-nucleation surface is thin enough to afford agglomeration when heat treatment as described below is applied. For example, a thickness of 0.1 »m or less is preferred, more preferably 0.06 »m or less.

Hereinafter, this film is called ultra-thin film.

Also, each of the above primary seeds has an area small enough to be agglomerated as a single agglomerate. For example, the diameter may be preferably 7 »m or less, more preferably 2 »m or less, optimally 1 »m or less.

When heat treatment is applied to the above primary seeds at a temperature of melting point or lower, agglomeration occurs as if in a liquid phase, whereby each area of the ultra-thin film becomes an agglomerated product. Its specific feature resides in that the agglomerates are monocrystalline and with constant and uniform face orientation.

As the material for the primary seed of the present invention, any material may be used that has remarkably larger surface area ratio relative to volume, consequently making the surface energy minimum with reduction of surface energy as the driving force to permit migration of atoms even in solid phase and cause agglomeration to occur at a temperature far lower than the melting point.

As the optimum material, there may be included semiconductors such as Ge, Si metals such as Cu, Ag, Au, Pt, Pd, etc. or alloys such as PtSi, InSn, etc.

The temperature at which the primary seeds are subjected to annealing is related to the material and the film thickness, etc. of the primary seeds, but is the melting point or lower, and the agglomeration initiation temperature or higher. For example, when the material of ultra-thin film is Ge, annealing may be applied at the agglomeration initiation temperature (600°C) or higher and the melting point (973°C) or lower.

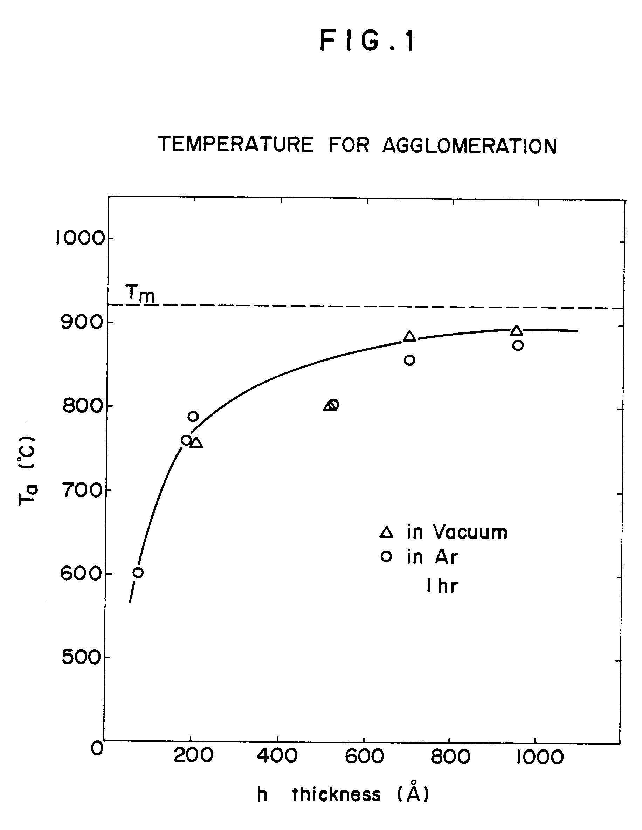

As can be seen from Fig. 1, the agglomeration temperature will be lowered with reduction in film thickness of the thin film. In the case of Ge film, as shown in Fig. 1, agglomeration begins at lower than the melting point (937°C), and when the film thickness becomes 15 nm (150 Å), the agglomeration initiation temperature is lowered even to 600°C. In the case of continuous film, when a Ge thin film of 20 nm (200Å) is formed on glass, quartz, Si0₂ such as thermally oxidised film, CVD film, etc. and annealed at 700°C for one hour, holes are formed in the film as the preceding stage to disruption.

When heat treatment is applied at 750°C for the same time, continuous film will be disrupted in the solid phase to become undesirably beads of some 100 nm (1000Å).

On the other hand, as the material to be grown, Ge, Si, GaAs, GaAlAs, etc. may be employed. That is, either homoepitaxial growth or heteroepitaxial growth can be practised.

For crystal growth suitable deposition methods such as CVD, liquid phase growth etc. may be employed.

### Example 1

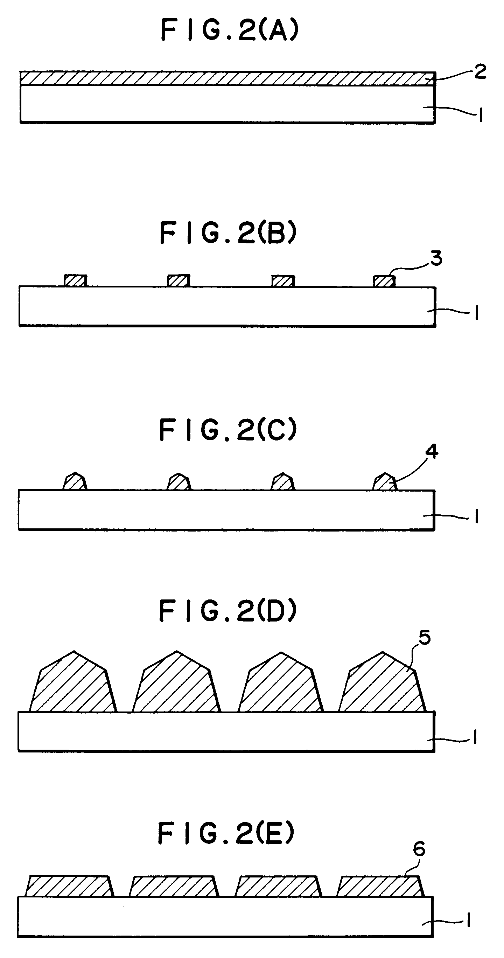

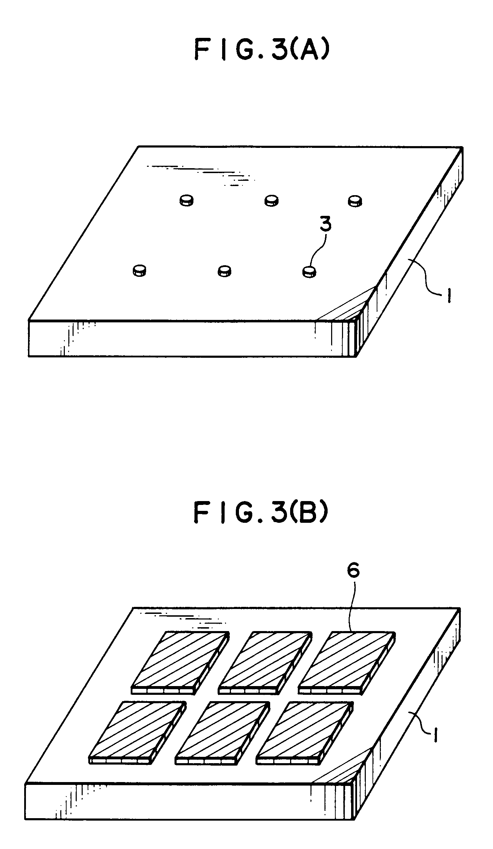

Example 1 is described below by referring to Fig. 2 and Fig. 3. On a silicon wafer substrate 1 having a Si0₂ layer deposited by the normal pressure CVD method (substrate temperature 400°C), an ultra-thin film comprising Ge with a film thickness of 20 nm (200 Å) was deposited by RF sputtering at a substrate temperature of 600°C (Fig. 2(A)).

The above ultra-thin film was found to be polycrystalline, and the face orientation vertical to the substrate 1 was <100>.

Next, patterning was effected with 2 »m squares at 50 »m intervals (Fig. 2(B)) to form primary seeds. As the patterning method, photolithography and reactive etching were employed.

Next, in an Ar atmosphere, annealing was conducted at 750°C for one hour. By carrying out such annealing, the primary seeds were caused to agglomerate as if they were in liquid phase each to give a respective agglomerate (Fig. 2(C)).

From observation by a transmission electron microscope, it was confirmed that each Ge agglomerated product is a monocrystal having internally no grain boundary and the face orientation in the direction vertical to the substrate 1 was uniformly oriented to <100>. Thus, the agglomerate becomes a monocrystal seed which maintains the face orientation observed before annealing.

Then, with each of the above agglomerates as a seed, heteroepitaxial growth of Si was performed by the CVD method. The growth conditions were as follows:
- temperature:: 950°C
- source gas:: SiH₂Cl₂
0.6 slm
- etching gas:: HCl
1.5 slm
- carrier gas:: H₂
100 slm
- pressure:: 20 kPa (150 Torr).

When the above growth was conducted for 30 minutes, growth proceeded from the seed onto the Si0₂ layer which was the non-nucleation surface, whereby monocrystals having sizes as large as 40 to 50 »m (hereinafter called "crystal islands") were grown (Fig. 2(D)).

As a result of X-ray diffraction narrowed to »mφ of each crystal island in a micro-portion X-ray diffraction device, all the face orientations vertical to the substrate 1 were confirmed to be oriented in the <100> direction. Thus, it can be understood that growth occurred with the direction of the Ge seed crystal being succeeded.

After the crystal island was flattened by lap and polishing (Fig. 2(E)), P-channel MOSFET was prepared thereon and its characteristics were examined. As a result, it was found to actuate similarly as that prepared on monocrystalline Si (100) wafer with the mobility of positive hole being 190 cm²/v.sec and leak current 10-¹¹ nm/»m (10⁻¹² Å/»m), thus exhibiting good characteristics.

### Example 2

In this Example, Si monocrystal was heteroepitaxially grown on monocrystal seeds in the same manner as in Example 1 except for using a substrate having Al₂0₃ surface.

By performing the above growth, the face orientation vertical to the substrate 1 was found to be oriented in the <100> direction similarly as in the case of Example 1, whereby crystal islands with sizes of 40 to 50 »m were grown.

On each of the above crystal island were prepared P-channel MOSFETs similarly as in Example 1, and the characteristics were examined. As a result, it was found to actuate similarly as that prepared on a monocrystal silicon wafer (100), with the mobility of positive holes being 190 cm²/v.sec and the leak current 10⁻¹¹ nm/»m (10⁻¹² Å/»m).

### Example 3

In this Example, according to the same method as in Example 1, an agglomerated product of Ge was formed to provide a monocrystal seed.

GaAs was grown according to the MOCVD method under the condition shown below. When crystal growth of GaAs was effected onto the monocrystal seed comprising an agglomerated product of Ge, with the substrate temperature being 670°C, the source gases being 50 sccm of arsine (AsH₃) and 2 sccm of trimethylgallium (TMG) and He being 30 slm as the carrier gas, GaAs monocrystal islands with diameter of about 40 »m were grown in 80 minutes, which were confirmed to be identical in direction with Ge monocrystal by micro-portion X-ray diffraction.

Under the growth condition no nucleation of GaAs occurred on Si0₂, but it was grown only on monocrystal Ge to cover over Si0₂.

### Example 4

In this Example, a monocrystal seed comprising an agglomerated product of Ge was formed similarly as in Example 1, and then Si monocrystal was grown from liquid phase on the seed.

Si monocrystal was grown by melting Si with Sn solvent at a cooling initiation temperature of 900 °C. The cooling speed was 0.2 °C/min. According to this method, a complete monocrystal was grown flatly in the lateral direction onto Si0₂, and yet it was also possible to grow monocrystal islands with an uniform face orientation similarly as the CVD method. Also, regular orientations were confirmed by micro-portion X-ray diffraction.

When a device was prepared on the crystal island formed in this Example similarly as in Example 1, it did actuate similarly as that prepared on a monocrystal Si (100) wafer.

### Example 5

In this Example, a monocrystal seed comprising an agglomerated product of Ge was formed similarly as in Example 4 except for making the intervals of patterning 100 »m, and then GaAs was grown from liquid phase.

Crystal growth of GaAs monocrystal was perfomed by use of Ga solvent with a cooling temperature of 0.7 °C/min. and a cooling initiation temperature of 750 °C. Within 15 minutes, large size monocrystal islands of about 70 to 100 »m were grown, and yet regular orientations were confirmed by micro-portion X-ray diffraction.

On the crystal island formed in this Example was prepared P-channel MOSFET similarly as in Example 1, and its characteristics were examined. As the result, it was formed to actuate similarly as that formed on monocrystal Si (100) wafer.

### Example 6

On a SiO₂ glass substrate, a polycrystalline silicon film with a thickness of 250 Å was formed by the LPCVD method.

Subsequently, the above polycrystalline silicon film was subjected to patterning to 0.4 »m square and 50 »m interval by photolithography and reactive etching to form primary seeds.

Next, the above primary seeds were annealed in hydrogen atmosphere at normal pressure at 1000 °C for 2 minutes to obtain monocrystalline seeds comprising an agglomerated product of silicon.

From observation by a transmission electron microscope, the respective silicon agglomerated products were found to be monocrystals having internally no grain boundary.

Subsequently, with the above agglomerated product as the seed, epitaxial growth of Si was performed by the CVD method under the following conditions:
substrate temperature : 1000 °C
amounts of gases introduced :
- SiH₂Cl₂ :: 0.53 slm
- HCl:: 1.8 slm
- H₂ :: 100 slm

pressure : 20 kPa (150 Torr)

When growth was performed under the above conditions for 30 minutes, the silicon monocrystal was epitaxially grown beyond the above seed crystal onto the SiO₂ glass substrate which is the non-nucleation surface, and its grain size was 45 to 50 »m.

### Example 7

On a quartz substrate, a polycrystalline silicon ultra-thin film with a thickness of 1000 Å was formed by the LPCVD method.

Subsequently, the above polycrystalline silicon ultra-thin film was subjected to patterning to 1.2 »m square and 60 »m interval by photolithography and reactive etching to form primary seeds.

Next, the above primary seeds were annealed in hydrogen atmosphere at normal pressure at 1010 °C for 3 minutes to form an agglomerated product of silicon.

From observation by a transmission electron microscope, the respective agglomerated silicon products were found to be monocrystals having no grain boundary.

Subsequently, with the above agglomerated product as the monocrystal seed, epitaxial growth of Si was conducted by the CVD method under the same conditions as in Example 6 for 30 minutes.

The crystals obtained were epitaxially grown beyond the seed crystals onto the quartz substrate which is the non-nucleation surface, with its grain size being 57 to 60 »m, and monocrystals with regular grain sizes could be obtained with good yield on the respective seed monocrystals.

## Claims

1. A method of growing monocrystalline material comprising the steps of:
providing a substrate (1) having a non-nucleation surface of small nucleation density for the monocrystalline material to be grown;
producing upon said non-nucleation surface of said substrate a plurality of monocrystalline seeds (4) having a constant and uniform face orientation; and
depositing crystal forming material (5) selectively upon said monocrystalline seeds and growing said crystal forming material epitaxially from each of said monocrystalline seeds;
which method is characterised in that:
said step of producing a plurality of monocrystalline seeds is performed by
producing a plurality of respective primary seeds (3) upon said non-nucleation surface of said substrate, each of said respective primary seeds being thin enough to agglomerate upon annealing, and of an area small enough for each of said respective primary seeds to be agglomerated each as a single agglomerate; and
annealing said respective primary seeds at a temperature which is not lower than the agglomeration temperature of said respective primary seeds and which is not higher than the melting point temperature of the material constituting said respective primary seeds, so to produce respective monocrystalline seeds having constant and uniform face orientation.

2. A method as claimed in claim 1 wherein said step of producing a plurality of respective primary seeds is performed by successive steps of:
depositing material which is to constitute said plurality of respective primary seeds to form a film of thickness not exceeding 0.1 »m; and
patterning said film to produce the plurality of respective primary seeds each of a diameter not exceeding 7 »m.

3. A method as claimed in either preceding claim wherein said plurality of respective primary seeds each have a thickness not exceeding 0.06 »m and a diameter not exceeding 1 »m.

4. A method as claimed in any preceding claim wherein said non-nucleation surface of the substrate is of amorphous insulating film.

5. A method as claimed in any preceding claim wherein said material constituting said plurality of respective primary seeds is of germanium, silicon, copper, silver, platinum, gold, palladium, Pt-Si alloy or In-Sn alloy.

6. A method as claimed in any of claims 1, 2 and 4 wherein said annealing is carried out in an atmosphere of hydrogen.

7. Use of a monocrystalline material produced by the method as claimed in any preceding claim in the production of an electronic device.

## Patentansprüche

1. Verfahren zum Züchten eines einkristallinen Materials, das die nachfolgenden Schritte umfaßt:
Bereitstellung eines Substrats (1) mit einer Nicht-Kristallkeimbildungsfläche von kleiner Kristallkeimbildungsdichte für das zu züchtende einkristalline Material;
Erzeugung auf der Nicht-Kristallkeimbildungsfläche des Substrats einer Vielzahl an einkristallinen Keimen (4) mit einer konstanten und gleichförmigen Flächenorientierung; und
selektive Abscheidung eines kristallbildenden Materials (5) auf den einkristallinen Keimen und Züchten des kristallbildenden Materials epitaxial aus jedem der einkristallinen Keime;
wobei das Verfahren **dadurch gekennzeichnet ist, daß** der Schritt der Herstellung einer Vielzahl an einkristallinen Keimen ausgeführt wird durch
Herstellung einer Vielzahl an entsprechenden primären Keimen (3) auf der Nicht-Kristalkeimbildungsfläche des Substrats, wobei jeder der entsprechenden primären Keime dünn genug ist, um beim Tempern zu agglomerieren, und eines Bereichs, der für jeden der entsprechenden primären Keime klein genug ist, daß jeder der primären Keime als einzelnes Agglomerat agglomeriert; und
Tempern der jeweiligen primären Keime bei einer Temperatur, die nicht tiefer als die Agglomerationstemperatur der entsprechenden primären Keime ist und die nicht höher als die Schmelzpunkttemperatur des Materials ist, das die jeweiligen primären Keime bildet, um so entsprechende einkristalline Keime mit konstanter und gleichförmiger Flächenorientierung zu erzeugen.

2. Verfahren nach Anspruch 1, **dadurch gekennzeichnet, daß** der Schritt der Erzeugung einer Vielzahl an entsprechenden primären Keimen durch die nachstehenden Schritte ausgeführt wird:
Abscheidung von Material, das die Vielzahl entsprechender primärer Keime bilden soll, unter Bildung eines Films mit einer Dicke, die 0,1 »m nicht übersteigt; und
Musterung des Films unter Erzeugung einer Vielzahl entsprechender primärer Keime, jeder mit einem Durchmesser, der 7 »m nicht übersteigt.

3. Verfahren nach einem der vorstehenden Ansprüche, **dadurch gekennzeichnet, daß** die Vielzahl der entsprechenden primären Keime jeweils eine Dicke, die 0,06 »m nicht übersteigt, und einen Durchmesser, der 1 »m nicht übersteigt, aufweist.

4. Verfahren nach einem der vorstehenden Ansprüche, **dadurch gekennzeichnet, daß** die Nicht-Kristallkeimbildungsfläche des Substrats ein amorpher Isolierfilm ist.

5. Verfahren nach einem der vorstehenden Ansprüche, **dadurch gekennzeichnet, daß** das Material, das die Vielzahl an entsprechenden primären Keimen bildet, Germanium, Silicium, Kupfer, Silber, Platin, Gold, Palladium, Pt-Si-Legierung oder In-Sn-Legierung ist.

6. Verfahren nach einem der Ansprüche 1, 2 und 4, **dadurch gekennzeichnet, daß** das Tempern in einer Wasserstoffatmosphäre durchgeführt wird.

7. Verwendung eines einkristallinen Materials, hergestellt durch das Verfahren nach einem der vorstehenden Ansprüche, bei der Herstellung einer elektronischen Vorrichtung.

## Revendications

1. Procédé pour faire croître un matériau mono-cristallin, comprenant les étapes suivantes:
l'utilisation d'un substrat (1) ayant une surface ne provoquant pas de nucléation à faible densité de nucléation pour le matériau monocristallin à faire croître;
la production, sur ladite surface ne provoquant pas de nucléation dudit substrat, d'un ensemble de germes (4) monocristallins ayant une orientation de face constante et uniforme; et
le dépôt sélectif d'un matériau (5) de formation de cristal sur lesdits germes monocristallins et la croissance dudit matériau de formation de cristal de façon épitaxiale à partir de chacun desdits germes monocristallins;
lequel procédé est caractérisé en ce que
ladite étape de production d'un ensemble de germes monocristallins est effectuée par:
production d'un ensemble de germes (3) primaires respectifs sur ladite surface ne provoquant pas de nucléation dudit substrat, chacun desdits germes primaires respectifs étant suffisamment mince pour s'agglomérer lors d'un recuit, et ayant une superficie suffisamment faible pour que chacun desdits germes primaires respectifs s'agglomère sous la forme d'un agglomérat unique; et
recuit desdits germes primaires respectifs à une température qui n'est pas inférieure à la température d'agglomération desdits germes primaires respectifs et qui n'est pas supérieure au point de fusion du matériau constituant lesdits germes primaires respectifs, de façon à produire des germes monocristallins respectifs ayant une orientation de face constante et uniforme.

2. Procédé selon la revendication 1, dans lequel ladite étape de production d'un ensemble de germes primaires respectifs est effectuée par les étapes successives suivantes:
le dépôt d'un matériau devant constituer ledit ensemble de germes primaires respectifs pour former un film ayant une épaisseur ne dépassant pas 0,1 »m; et
la formation d'un motif sur ledit film pour produire l'ensemble de germes primaires respectifs ayant chacun un diamètre ne dépassant pas 7 »m.

3. Procédé selon l'une quelconque des revendications précédentes, dans lequel chacun dudit ensemble de germes primaires respectifs a une épaisseur ne dépassant pas 0,06 »m et un diamètre ne dépassant pas 1 »m.

4. Procédé selon l'une quelconque des revendications précédentes, dans lequel ladite surface ne provoquant pas de nucléation du substrat est constituée d'un film isolant amorphe.

5. Procédé selon l'une quelconque des revendications précédentes, dans lequel ledit matériau constituant ledit ensemble de germes primaires respectifs est constitué de germanium, de silicium, de cuivre, d'argent, de platine, d'or, de palladium, d'un alliage de Pt-Si ou d'un alliage d'In-Sn.

6. Procédé selon l'une quelconque des revendications 1, 2 et 4, dans lequel ledit recuit est effectué dans une atmosphère d'hydrogène.

7. Utilisation d'un matériau monocristallin produit par le procédé selon l'une quelconque des revendications précédentes, dans la production d'un dispositif électronique.
